(19) Europäisches Patentamt
European Patent Office
Office européen des brevets

(11) **EP 1 903 673 B1**

(12) **EUROPÄISCHE PATENTSCHRIFT**

(45) Veröffentlichungstag und Bekanntmachung des Hinweises auf die Patenterteilung:
**23.03.2011   Patentblatt 2011/12**

(51) Int Cl.:
***H03F 3/45*** *(2006.01)*

(21) Anmeldenummer: **07014629.5**

(22) Anmeldetag: **25.07.2007**

(54) **Regelkreis zur thermischen Kompensation eines elektronischen Verstärkerpfads**

Regulator circuit for thermal compensation of an electronic amplifying path

Circuit régulateur pour la compensation thermique d'une voie électronique d'amplification

(84) Benannte Vertragsstaaten:
**DE FR GB**

(30) Priorität: **25.09.2006   DE 102006045184**

(43) Veröffentlichungstag der Anmeldung:
**26.03.2008   Patentblatt 2008/13**

(73) Patentinhaber: **Rohde & Schwarz GmbH & Co. KG**
**81671 München (DE)**

(72) Erfinder: **Dümler, Ulrich**
**82024 Taufkirchen (DE)**

(74) Vertreter: **Körfer, Thomas et al**
**Mitscherlich & Partner**
**Patent- und Rechtsanwälte**
**Postfach 33 06 09**
**80066 München (DE)**

(56) Entgegenhaltungen:
US-A- 4 088 962          US-A- 5 568 093
US-A1- 2004 043 742     US-A1- 2005 140 445
US-B1- 6 753 732

EP 1 903 673 B1

**Beschreibung**

Die Erfindung bezieht sich auf einen Regelkreis für die thermische Kompensation der thermischen Drift eines elektronischen Verstärkerpfades.

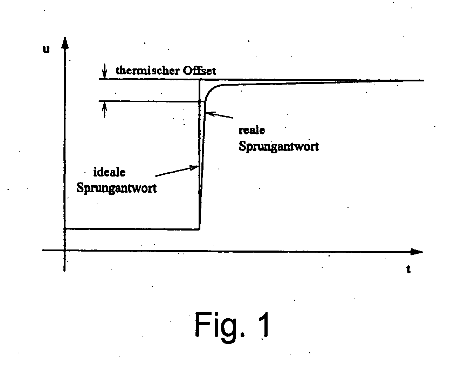

Die Eigenschaften elektronischer Bauelemente und Schaltungen haben eine ausgeprägte Abhängigkeit von der Temperatur. Typische Verstärker-Grundschaltungen neigen daher dazu, eine thermische Drift zu zeigen. Dies wird bei Anlegen eines Rechtecksignals deutlich und ist in Fig. 1 dargestellt. Diese Drift, oft auch als thermischer Offset beschrieben, ist das Ergebnis der sich ändernden Verlustleistung an einzelnen Bauelementen aufgrund des sich ändernden Signals. Daraus folgt eine Änderung der Temperatur einzelner Bauelemente. Diese Temperaturänderung erfolgt mit einer thermischen Zeitkonstante. Gemäß der zugrunde liegenden Exponentialfunktion ändert sich die Temperatur der Bauelemente und damit deren Kennlinien. Daher driftet das Ausgangssignal der Verstärkerschaltung langsam seinem Endwert zu.

Die Abhängigkeit der Basis-Emitter-Spannung von der Temperatur ist bei Silizium-Bipolartransistoren und auch bei Silizium-Germanium-Bipolartransistoren die dominante Größe und liegt allgemein im Bereich von -1,5 ... 2 mV/K. Eine Kompensation dieser Größe ist eine Maßnahme, die den thermischen Offset deutlich verringert.

In der US 4,146,844 wird eine erweiterte Grundschaltung, bestehend aus dem eigentlichen Differenzverstärker, einem weiteren kompensierenden Differenzverstärker beschrieben, welche bei richtiger Dimensionierung eine verminderte thermische Drift zeigt. Eine Regelung findet jedoch nicht statt. Auch ist die nachfolgende Stufe nicht in die Stabilisierung einbezogen.

Ein Regelkreis zur thermischen Kompensation eines Differenzverstärkers ist aus der US 6,753,732 bekannt.

Die Aufgabe der Erfindung ist es prinzipiell den Einfluß der Temperatur auf eine vorgegebene Verstärkerschaltung zu minimieren.

Die Aufgabe wird durch die Merkmale des Anspruchs 1 gelöst. Vorteilhafte Weiterbildungen gehen aus den Unteransprüchen hervor.

Diese erfinderische Vorgehensweise hat folgende Vorteile gegenüber anderen Lösungen:

Schwankungen der Arbeitspunkte werden durch eine solche Regelung erfasst und kompensiert. Die Kompensation der thermischen Offsets wird dadurch zuverlässig gewährleistet und ist nicht mehr an eine exakte Dimensionierung gebunden.

Da keine zusätzlichen Transistoren oder Kompensationsnetzwerke gegenüber anderen Verfahren im Signalpfad der Schaltung eingefügt werden müssen, sind maximale Grenzfrequenzen aufgrund der minimalen Anzahl von Transistoren im Signalpfad erzielbar. Bezüglich der physikalischen Größe der Transistoren gibt es mathematisch keine Einschränkung.

Die Umgebungstemperatur der einzelnen Grundschaltungen muss nicht gleich sein. Es ergeben sich daher keine Einschränkungen bezüglich der geometrischen Lage z.B. in einer integrierten Schaltung.

Werden in einer diskreten Schaltung nur Transistoren derselben Technologie verwendet, d.h. die elektrischen und thermischen Zeitkonstanten sind gleich, ist dieses Verfahren auch auf diskrete Schaltungen anwendbar.

Darüber hinaus ist die erfindungsgemäße Vorgehensweise prinzipiell auf verschiedene Kombinationen von Grundschaltungen anwendbar und beschränkt sich nicht auf die hier exemplarisch vorgestellte Schaltung.

Die exemplarisch vorgestellte Schaltung ist typisch für einen Verstärkerblock und besitzt gegenüber der in der US 4,146,844 dargestellten Schaltungen den Vorteil, dass sie mehrfach in Reihe geschaltet werden kann.

Allgemein kann die thermische Drift von aufeinander folgenden Schaltungsteilen durch geeignete Dimensionierung gegenseitig kompensiert werden. Eine andere Möglichkeit ist es, die Verlustleistung an den entscheidenden Transistoren im Signalpfad durch zusätzliche Schaltungsmaßnahmen konstant zu halten.

Das Prinzip der starken Gegenkopplung bei gleichzeitig hoher Leerlaufverstärkung minimiert prinzipiell den Einfluss der Temperatur.

Die Erfindung wird nachfolgend unter Bezugnahme auf die Zeichnungen näher beschrieben. In den Zeichnungen zeigen:

Fig. 1    den Vergleich der idealen und realen Sprungantwort zur Erläuterung des Problems des thermischen Offsets bei Verstärkerschaltungen;

Fig. 2    ein Ausführungsbeispiel des erfindungsgemäßen Regekreises;

Fig. 3    ein Ausführungsbeispiel von zwei Teilschaltungen zur Realisierung des erfindungsgemäßen Regelkreises;

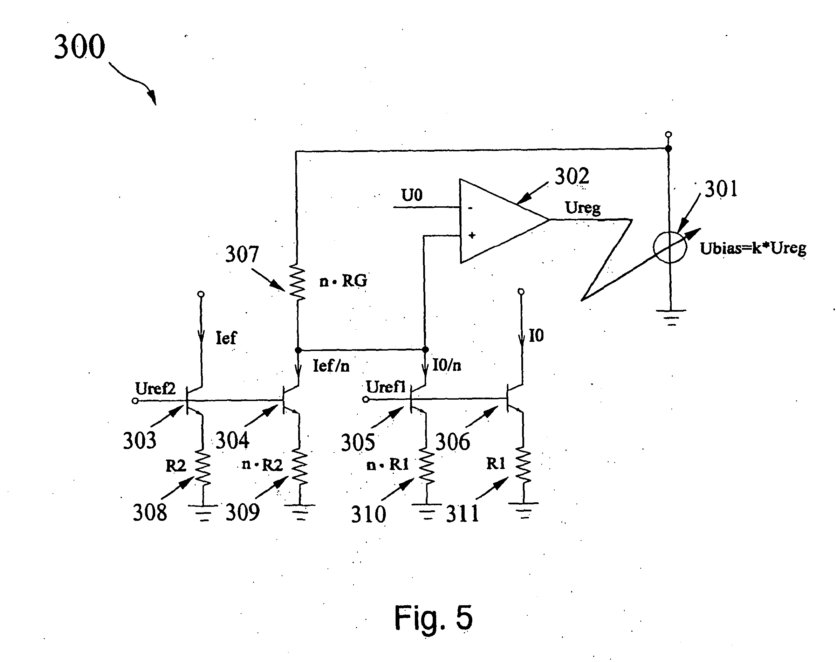

Fig. 4    den prinzipiellen Verlauf der Sprungantwort der Teilschaltungen, wie in Fig. 2 gezeigt;

Fig. 5    ein Ausführungsbeispiel einer weiteren Teilschaltung mit einer Reglerfunktion zur Realisierung des erfindungsgemäßen Regelkreises; und

Fig. 6    ein Simulationsergebnis der Schaltung nach Fig. 3 und 5 mit und ohne Arbeitspunktregelung.

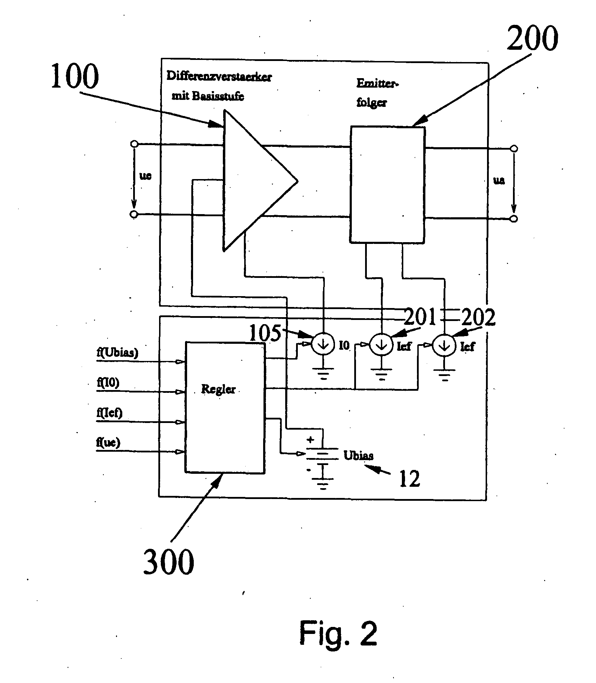

In Fig. 2 ist ein Ausführungsbeispiel des erfindungsgemäßen Regelkreises als Blockschaltbild dargestellt. Der erfindungsgemäße Regelkreis besteht aus einer Differenzverstärkereinheit 100, vorzugsweise mit Basistufe, und einem der Differenzverstärkereinheit 100 nachgeschalteten Emitterfolger 200 sowie einer Regeleinheit 300, die aus mehreren Regelgrößen der Differenzverstärkereinheit 100 und/oder des Emitterfolgers 200 zumindest eine Stellgröße bestimmt, die das Verhalten der Differenzverstärkereinheit 100 und/oder des Emitterfolgers 200 regelt.

f(Ubias), f(I0), f(Ief) und f(ue) stellen Messsignale dar, die den zu messenden Größen Ubias, I0, Ief und dem Eingangssignal ue proportional sind. In dem Regler ist die mathematische Funktion implementiert, die die Kompensation gewährleistet. Insbesondere ist es möglich, eine Kleinsignalnäherung, d.h. f(ue)=0, zu implementieren. Weiterhin ist es möglich, nur eine der drei Größen Ubias, I0 und Ief zu regeln, siehe später G1.(11), (12) und (13).

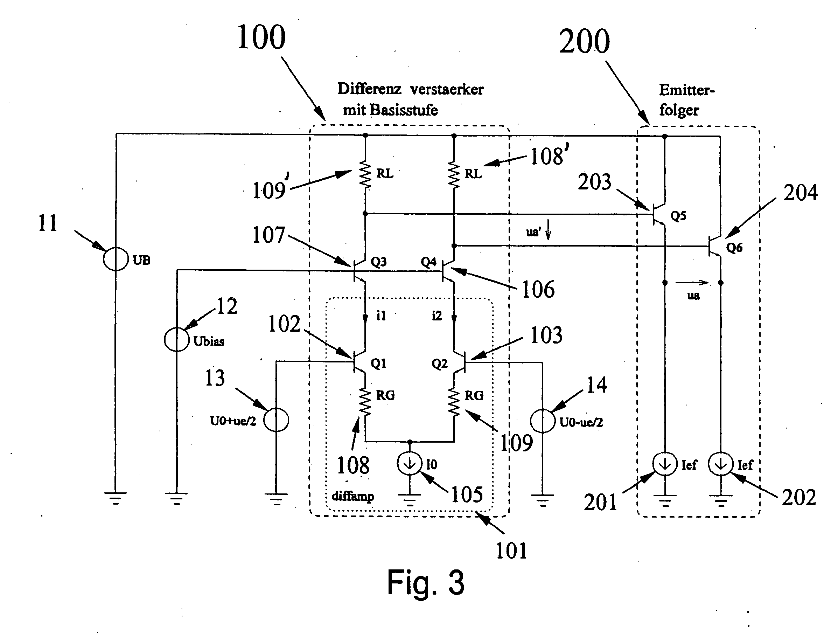

Im folgenden Abschnitt folgt eine genaue Beschreibung des Ausführungsbeispiels der Schaltung aus der Fig. 3. Die Differenzverstärkereinheit 100 besteht aus einem Differenzverstärker 101 mit den Transistoren 102 und 103, die auch mit Q1 und Q2 bezeichnet sind, zweier Emitter-Widerstände 108 und 109 mit dem Widerstandswert RG und einer Stromquelle 105, die einen Strom I0 auf die Verstärkerschaltung einprägt, einer Basisstufe mit den Transistoren 106 und 107, die auch mit Q3 und Q4 bezeichnet sind, und zwei Last-Widerständen 108' und 109' mit dem Widerstandswert RL, einem Emitterfolger 200 mit den Transistoren 203 und 204, die auch mit Q5 und Q6 bezeichnet sind, und je zwei Stromquellen 201 und 202, die einen Emitter-Strom Ief einprägen, sowie einer Versorgungsspannungsquelle 11 mit der Betriebsspannung UB.

Ein Anschluss der Stromquelle 105 der Differenzverstärkereinheit 100 ist mit Masse verbunden. Der zweite Anschluss der Stromquelle 105 ist mit jeweils einem Anschluss der Widerstände 108 und 109 verbunden. Die Widerstände 108 und 109 sind jeweils mit ihrem zweiten Anschluss mit den Emittern der Transistoren 102 und 103 verbunden. Die Kollektoren der Transistoren 102 und 103 erhalten die Ströme i1 und i2 und sind jeweils mit den Emitterkontakten der Transistorelemente 106 und 107 verbunden. Die Basis der Transistoren 102 und 103 ist jeweils mit den Spannungsquellen 13 und 14 verbunden.

Die Kollektoren der Transistoren 106 und 107 mit der Bezeichnung Q3 und Q4 sind mit jeweils einem Anschluss der Last-Widerstände 108' und 109' mit dem Widerstandswert RL der Basisstufe, bestehend aus den Elementen 106, 107, 108' und 109' verbunden. Die zweiten Anschlüsse der Widerstände 108' und 109' sind mit der Versorgungsspannungquelle 11 mit der Versorgungsspannung UB verbunden.

Ein Anschluss der Stromquellen 201 und 202, die den Strom Ief einprägen, ist mit Masse verbunden. Der zweite Anschluss der Stromquellen 201 und 202 ist jeweils mit den Emittern der Transistoren 203 und 204 mit der Bezeichnung Q5 und Q6 verbunden. Die Kollektoren der Transistoren 203 und 204 mit der Bezeichnung Q5 und Q6 sind mit der Versorgungsspannungsquelle 11 verbunden, die die Spannung UB bereitstellt. Die Basisanschlüsse der Transistoren 203 und 204 mit den Bezeichnungen Q5 und Q6 sind mit den ersten Anschlüssen der Last-Widerstände 108' und 109' und den Kollektoren der Transistorelemente 106 und 107 mit der Bezeichnung Q3 und Q4 verbunden. Die Ausgangsspannung ua wird zwischen den Emittern der Transistorelemente 203 und 204 mit den Bezeichnungen Q5 und Q6 abgegriffen.

In Fig. 3 wird die Kombination von Differenzverstärker 101 mit Basisstufe 106, 107 und Emitterfolger 200 betrachtet. Durch die Analyse des Übertragungsverhaltens ergibt sich eine mathematische Bedingung, die die Arbeitspunkte Ubias, I0 und Ief der einzelnen Grundschaltungen derart verknüpft, dass thermisch bedingte Offsets sich gegenseitig ausgleichen. Dieser Ausgleich beruht auf dem Effekt, dass die thermischen Offsets der zwei Schaltungsteile entgegen gesetzte Vorzeichen haben. Dies ist in Fig. 3 dargestellt. Sind die Arbeitspunkte der Grundschaltungen richtig eingestellt, so gleichen sie sich zu allen Zeiten aus.

Hierbei wird lediglich vorausgesetzt, dass die einzelnen Transistoren dieselbe thermische Zeitkonstante haben. In einer integrierten Schaltung ist dies gegeben.

Die als diffamp bezeichnete Struktur stellt einen einfachen Differenzverstärker dar. Der Zusammenhang zwischen differenziellen Ausgangsstrom ia = i1 - i2 und differenziellen Eingangssignal ue ist:

$$(1) \qquad ia = gm^{*} \cdot ue$$

wobei

$$gm^* = \frac{dia}{due} \approx \frac{1}{RG}$$

Für die Basisstufe mit Q3 und Q4 gilt näherungsweise: ic = ie, sodass die Kleinsignalverstärkung

$$(2) \qquad vu = \frac{ua'}{ue} = -gm^* \cdot RL \approx -\frac{RL}{RG}$$

ist.

Betrachtet man die Schaltung aus Fig. 3, so wird bei Anlegen eines Spannungssprungs am Eingang der Höhe ue sich der Stromfluss durch die Transistoren Q1 und Q2 und die Spannungen ua' und ua ändern. Es ändern sich die Verlustleistungen an den Transistoren und damit die Transistortemperaturen. Die bei gleichem Stromfluss abfallende Basis-Emitter-Spannung ändert sich mit $\dfrac{dube}{dT} \approx -2\dfrac{mV}{K}$ und ist in guter Näherung linear.

Eine Änderung der Basis-Emitter-Spannung von Q1,Q2 aufgrund von Temperaturänderungen erscheint mit vu verstärkt an den Eingängen der Emitterfolger. Da sich ua' aufgrund ue ändert, ändern sich auch die Verlustleistungen und die Temperaturen von Q5,Q6. Aufgrund der sich ändernden Temperaturen werden sich die Basis-Emitter-Spannung der Emitterfolger Q5,Q6 ändern. Wenn die Bedingungen:

$$(3) \qquad -vu \cdot \frac{dube}{dT} \cdot \Delta T_{Q1} = \frac{dube}{dT} \cdot \Delta T_{Q5}$$

bzw.

$$(4) \qquad -vu \cdot \frac{dube}{dT} \cdot \Delta T_{Q2} = \frac{dube}{dT} \cdot \Delta T_{Q6}$$

eingehalten werden, sind die thermischen Offsets von Q1 und Q5 bzw. Q2 und Q6 gleich und kompensieren sich gegenseitig.

Die Verlustleistung der Transistoren im Arbeitspunkt berechnet sich über Pv = Uce·Ic für Q1,Q2 zu

$$(5) \qquad Pv_{Q1,2} = (Ubias - U0) \cdot \frac{I0}{2}$$

und für die Transistoren Q5,Q6 zu

$$(6) \qquad Pv_{Q5,6} = \left(\frac{I0}{2} \cdot RL + Ube\right) \cdot Ief$$

Die Verlustleistung bestimmt zusammen mit dem thermischen Widerstand Rth zwischen Bipolartransistor und Umgebung, dem Substrat, die Temperatur des Transistors:

$$(7) \qquad T_Q - T_{amb} = Pv \cdot Rth$$

Eine Änderung der Verlustleistung ΔPv verursacht eine Änderung der Temperaturdifferenz zur Umgebung:

$$(8) \qquad \Delta T_Q = \Delta Pv \cdot Rth$$

Legt man an den Eingang des Differenzverstärkers die Spannung ue an, ergibt sich an Q1 die Verlustleistung

$$Pv_{Q1} = (Ubias - U0) \cdot \frac{I0}{2} + (Ubias - U0) \cdot \frac{gm^*}{2} \cdot ue - ue \frac{I0}{2} - \frac{gm^*}{4} \cdot ue^2$$

und damit eine Änderung

$$(9)$$

$$\Delta Pv_{Q1} = (Ubias - U0) \cdot \frac{gm^*}{2} \cdot ue - \frac{I0}{2} ue - \frac{gm^*}{4} \cdot ue^2$$

Für Q5 ist die Verlustleistung nun

$$Pv_{Q5} = \left( \frac{I0}{2} \cdot RL + \frac{gm^*}{2} \cdot RL \cdot ue + Ube \right) \cdot Ief$$

und die Änderung

$$(10) \qquad \Delta Pv_{Q5} = \frac{gm^*}{2} \cdot RL \cdot Ief \cdot ue$$

Aus (3) und (8) ergibt sich

$$- vu \cdot Rth_{Q1} \cdot ue \cdot \left[ (Ubias - U0) \cdot \frac{gm^*}{2} - \frac{I0}{2} - \frac{gm^*}{4} \cdot ue^2 \right] =$$

$$Rth_{Q5} \cdot \frac{gm^*}{2} \cdot RL \cdot Ief \cdot ue$$

$$- vu \cdot \frac{Rth_{Q1}}{Rth_{Q5}} \left[ (Ubias - U0) - \frac{I0}{gm^*} - \frac{ue}{2} \right] = RL \cdot Ief$$

mit $gm^* \approx \frac{1}{RG}$ und $vu \approx -\frac{RL}{RG}$

$$(11) \qquad \frac{Rth_{Q1}}{Rth_{Q5}} \left[ \frac{(Ubias - U0)}{RG} - I0 - \frac{ue}{2 \cdot RG} \right] = Ief$$

$$(12) \qquad (Ubias - U0) = \left( \frac{Rth_{Q5}}{Rth_{Q1}} Ief + I0 \right) \cdot RG + \frac{ue}{2}$$

$$(13) \qquad \frac{(Ubias - U0)}{RG} - \frac{Rth_{Q5}}{Rth_{Q1}} Ief - \frac{ue}{2 \cdot RG} = I0$$

Die Ausdrücke (11), (12) und (13) sind äquivalent und stellen eine Bedingung dar, wann die Schaltung keine thermische Drift zeigt.

Die hier beschriebene Ausführungsform der Erfindung ist derart, dass die Arbeitspunkte der einzelnen Grundschaltungen gemessen und die Arbeitspunkte der Grundschaltungen so geregelt werden, dass die mathematische Bedingung erfüllt ist.

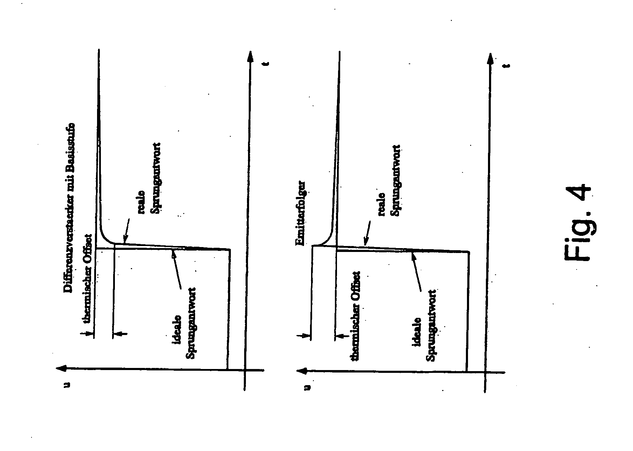

Fig. 5 zeigt eine einfache Implementierung der Regeleinheit 300. Hierbei ist $Rth_{Q1} = Rth_{Q5}$ angenommen, es wird im dargestellten Ausführungsbeispiel lediglich Ubias geregelt.

Nachfolgend eine Beschreibung der Schaltung gemäß dem Ausführungsbeispiel der Fig. 5 gegeben. Die Regeleinheit 300 besteht aus einem Differenzverstärker 302, vier Transistoren 303 bis 306, fünf Widerständen 307 bis 311 und ist an eine Spannungsquelle 301 angeschlossen.

Der Transistor 303 erhält an seinem Kollektor einen Strom Ief, an seiner Basis eine Referenzspannung Uref2 und ist mit seinem Emitter über einen Widerstand 308 mit Widerstandswert R2 mit Masse verbunden. Der Transistor 304 ist mit seinem Kollektor mit einem Anschluss des Widerstands 307, mit dem Kollektor des Transistors 305 sowie mit dem positiven Eingangstor (+) des Differenzverstärkers 302 verbunden. Die Basis des Transistors 304 ist zusammen mit der Basis des Transistors 303 mit der Referenzspannung Uref2 verbunden. Der Emitter des Transistors 304 ist über den Widerstand 309 mit dem Widerstandswert n·R2 mit Masse verbunden. Der Kollektor des Transistors 304 erhält den Strom Ief/n.

Der Kollektor des Transistors 305 erhält einen Strom I0/n. An der Basis des Transistors 305 ist eine Referenzspannung Uref1 angeschlossen. Der Emitter des Transistors 305 ist über einen Widerstand 310 mit dem Widerstandswert n·R1 mit Masse verbunden. Der Transistor 306 erhält an seinem Kollektor den Strom I0 und ist an seiner Basis zusammen mit der Basis des Transistors 305 mit der Referenzspannung Uref1 verbunden. Das Transistorelement 306 ist mit seinem Emitter über einen Widerstand 311 mit dem Widerstandswert R1 mit Masse verbunden.

Der Differenzverstärker 302 erhält an seinem negativen Eingangstor (-) die Spannung U0 und gibt an seinem Ausgang die Regelspannung Ureg aus, die die Spannungsquelle 301 ansteuert. Die Spannung Ubias der Spannungsquelle 301 berechnet sich aus der Ausgangsspannung Ureg über eine Proportionalverstärkung k gemäß der Formel Ubias=k*Ureg.

Das positive Eingangstor (+) des Differenzverstärkers 302 erhält eine Spannung, die sich aus dem Spannungsabfall an dem Spannungsteiler bestehend aus dem Widerstand 307 und dem Transistornetzwerk 304, 305, 309, 310 ergibt. Der Widerstand 307 hat einen um den Faktor n höheren Widerstandswert n·RG als der Widerstandswert RG der Emitterwiderstände 108, 109 des Differenzverstärkers 101 in Fig. 3. Das Transistornetzwerk besteht im dargestellten Ausführungsbeispiel aus einem ersten Transistor 304 in Emitterschaltung mit dem Emitterwiderstand 309, welche einen ersten Zweig bilden, und einem zweiten Zweig, bestehend aus dem Transistor 305, ebenfalls in Emitterschaltung, und dem Emitterwiderstand 310.

Der Widerstandswert n·R2 ist um den Faktor n größer als der Widerstandswert R2 des Emitterwiderstands 308 des Transistors 303, welcher den Emitterstrom Ief durch jeden Emitter der beiden Transistoren 203 und 204 des Emitterfolgers 200 regelt. Entsprechend ist der Widerstandswert n·R1 des Emitterwiderstands 310 um den Faktor n größer als der Widerstandswert R1 des Emitterwiderstands 311 des Transistors 306, welcher den Gesamtstrom I0 des Differenzverstärkers 101 regelt. Die Basen der Transistoren 303 und 304 sind miteinander verbunden, so dass an beiden Transistoren die gleiche Referenzspannung Uref2 anliegt. Entsprechend sind auch die Basen der beiden Transistoren 305 und 306 miteinander verbunden, so dass dort die gleiche Referenzspannung Uref1 anliegt. Die Transistoren 304 und 305 sind kollektorseitig miteinander verbunden.

Die von dem Differenzverstärker 302 in Verbindung mit der Spannungsquelle 301 geregelte Spannung Ubias bildet die Basisspannung für die Transistoren 106 und 102 der Basisstufe. Die Spannungsquelle 301 in Fig. 5 entspricht daher der Spannungsquelle 12 in Fig. 3. Der Transistor 303 bildet einen Stromregler für den Strom Ief und entspricht den Stromquellen 201 und 202 in Fig. 3. Der Transistor 306 bildet einen Stromregler für den Strom I0 und entspricht der Stromquelle 105 in Fig. 5. Die Referenzspannung U0 entspricht dem Mittelwert des von den Spannungsquellen 13 in Fig. 3 erzeugten Spannungswerts U0+ue/2, welcher an der Basis des Transistors 102 anliegt, und des von der Spannungsquelle 14 erzeugten Spannungswerts U0-ue/2, welcher an der Basis des Transistors 103 anliegt.

Mit dem in Fig. 5 dargestellten Ausführungsbeispiel lässt sich eine besonders einfache analoge Regelung schaffen, die den in Gleichung (12) angegebenen Zusammenhang zwischen der geregelten Basisspannung Ubias, der Referenzspannung U0 und den Strömen Ief und I0 darstellt.

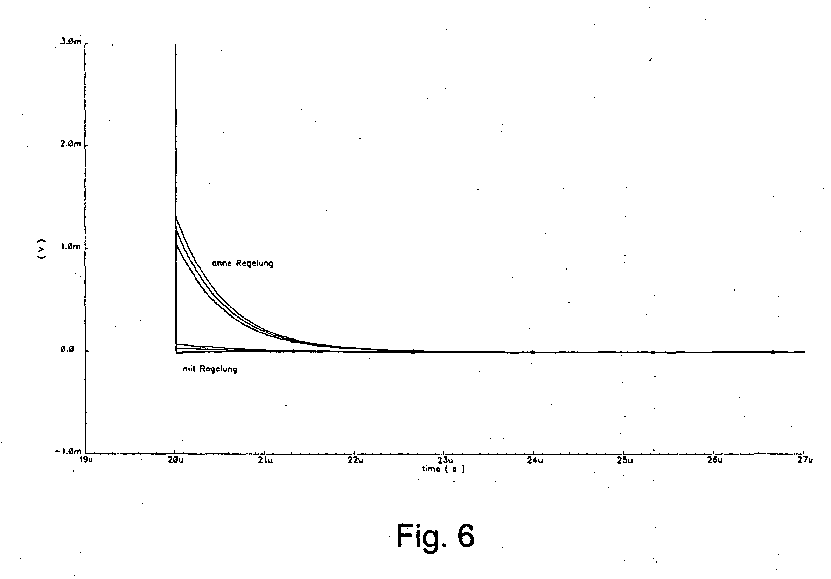

In Fig. 6 ist die Wirkung der Regelung eindeutig erkennbar. Die dargestellten Signale stellen in Fig. 2 das Signal ua dar. Um die Wirksamkeit der Regelung nachzuweisen, wurde die Arbeitspunktgröße I0 um 40% variiert. Wenn zwei statt ein Emitterfolger verwendet werden, kann unter Berücksichtigung der geänderten Kompensationsbedingung in den Gleichungen (11), (12) und (13) - es würde ein weiterer Term mit Ief2 auftreten - eine noch bessere Kompensation erfolgen.

Die Erfindung ist nicht auf die beschriebenen Ausführungsbeispiele beschränkt. Der erfindungsgemäße Regelkreis zur thermischen Kompensation kann vielfältig zum Einsatz kommen.

**Patentansprüche**

1. Regelkreis mit einer Differenzverstärkereinheit (100), einem der Differenzverstärkereinheit (100) nachgeschalteten Emitterfolger (200) und einer Regeleinheit (300), wobei die Regeleinheit (300) so konfiguriert ist, dass sie aus Regelgrößen (I0, Ief) sowohl der Differenzverstärkereinheit (100) als auch des Emitterfolgers (200) zumindest eine Stellgröße (Ubias) bestimmt, die das Verhalten der Differenzverstärkereinheit und/oder des Emitterfolgers (200) regelt, wobei die Differenzverstärkereinheit (100) einen Differenzverstärker (101) mit Transistoren (102,103) und Emitter-Widerständen (108,109), eine Basisstufe mit Transistoren (107,106) umfasst,
**dadurch gekennzeichnet,**
**dass** der Regelkreis so konfiguriert ist, dass er eine thermische Drift durch das Einstellen einer Spannung Ubias, die an den Basen der Transistoren (107, 106) der Basisstufe angeschlossen ist, als Stellgröße gemäß der Gleichung

$$(\text{Ubias} - \text{U0}) = \left( \frac{\text{Rth}_{Q5}}{\text{Rth}_{Q1}} \text{Ief} + \text{I0} \right) \cdot \text{RG} + \frac{\text{ue}}{2} \ ,$$

kompensiert, worin I0 den Gesamtstrom des Differenzverstärkers (101) der Differenzverstärkereinheit (100), Ief den Emitterstrom des Emitterfolgers (200), U0 eine Referenzspannung, RG den Widerstandswert der Emitter-Widerstände (108, 109) des Differenzverstärkers (101), ue den Spannungsunterschied an den Basen der Transistoren (102, 103) des Differenzverstärkers (101) und $\text{Rth}_{Q5}$ sowie $\text{Rth}_{Q1}$ Konstanten darstellen.

2. Regelkreis nach Anspruch 1,
**dadurch gekennzeichnet,**
**dass** die Basisstufe einen ersten Transistor (107) und einen zweiten Transistor (106) umfasst.

3. Regelkreis nach Anspruch 2,
**gekennzeichnet dadurch,**
**dass** die Differenzverstärkereinheit (100) zwei Last-Widerstände (108', 109') umfasst.

4. Regelkreis gemäß Anspruch 3,
**dadurch gekennzeichnet,**
**dass** der Differenzverstärker (101) einen ersten Transistor (102), der seriell zu einem ersten Transistor (107) der Basisstufe angeordnet ist, einen zweiten Transistor (103), der seriell zu dem zweiten Transistor (106) der Basisstufe angeordnet ist sowie einen ersten Emitter-Widerstand (108) und einen zweiten Emitter-Widerstand (109) umfasst, wobei die Emitter-Widerstände (108, 109) mit einer ersten Stromquelle (105) verbunden sind.

5. Regelkreis gemäß Anspruch 4,
**dadurch gekennzeichnet,**

**dass** der Emitterfolger (200) einen ersten Transistor (203), dessen Basis mit dem Kollektor des ersten Transistors (107) der Basisstufe verbunden ist, und einen zweiten Transistor (204), dessen Basis mit dem Kollektor des zweiten Transistors (106) der Basisstufe verbunden ist umfasst, wobei zumindest eine zweite Stromquelle (201, 202) mit dem Emitter des ersten Transistors (203) und/oder mit dem Emitter des zweiten Transistors (204) des Emitterfolgers (200) verbunden ist.

6. Regelkreis gemäß Anspruch 5,
   **dadurch gekennzeichnet,**
   **dass** die Regeleinheit (300) eine steuerbare Spannungsquelle (301), einen Differenzbildungseinheit (302) und mehrere Stromregler (303; 306) umfasst.

7. Regelkreis gemäß Anspruch 6,
   **dadurch gekennzeichnet,**
   **dass** ein erster Stromregler (303) so konfiguriert ist, dass er mit dem von der zweiten Stromquelle (201, 202) erzeugten Emitterstrom (Ief) des Emitterfolgers (200) durchflossen ist.

8. Regelkreis gemäß Anspruch 7,
   **dadurch gekennzeichnet,**
   **dass** ein zweiter Stromregler (306) so konfiguriert ist, dass er mit dem von der ersten Stromquelle (105) erzeugten Gesamtstrom (I0) des Differenzverstärkers (101) durchflossen ist.

9. Regelkreis gemäß Anspruch 8,
   **dadurch gekennzeichnet,**
   **dass** am negativen Eingang (-) der Differenzbildungseinheit (302) eine Referenzspannung (U0) angelegt ist, welche dem Mittelwert der Basisspannungen (U0+ue/2; U0-ue/2) der Transistoren (102, 103) des Differenzverstärkers (101) entspricht.

10. Regelkreis gemäß Anspruch 9,
    **dadurch gekennzeichnet,**
    **dass** die Differenzbildungseinheit (302) die Differenz aus der Referenzspannung (U0) und einer Spannung bildet, die am positiven Eingang (+) der Differenzbildungseinheit (302) anliegt.

11. Regelkreis gemäß Anspruch 10,
    **dadurch gekennzeichnet,**
    **dass** die Spannung, welche am positiven Eingang (+) der Differenzbildungseinheit (302) anliegt, durch den Spannungsabfall gebildet ist, welcher von dem durch einen Teiler (n) geteilten Emitterstrom (Ief) des Emitterfolgers (200) und dem durch den gleichen Teiler (n) geteilten Gesamtstrom (I0) des Differenzverstärkers (101) an einem Spannungsteiler erzeugt wird.

12. Regelkreis nach Anspruch 11,
    **dadurch gekennzeichnet,**
    **dass** der Spannungsteiler aus einem ersten Widerstand (307) und einem Transistornetzwerk (304, 305, 309, 310) besteht.

13. Regelkreis nach Anspruch 12,
    **dadurch gekennzeichnet,**
    **dass** das Transistornetzwerk aus zwei parallelen Zweigen mit jeweils einem Transistor (304; 305) in Emitterhaltung und einem Emitterwiderstand (309, 310) besteht, wobei eine Basis der beiden Transistoren (304, 305) mit dem ersten Stromregler (303) und die andere Basis der beiden Transistoren (304, 305) mit dem zweiten Stromregler (306) verbunden ist.

14. Regelkreis gemäß einem der Ansprüche 8 bis 13,
    **dadurch gekennzeichnet,**
    **dass** an die Differenzbildungseinheit (30) eine Spannungsquelle (301) angeschlossen ist, welche von der Ausgangsspannung (Ureg) der Differenzeinheit (302) angesteuert wird und die Spannung Ubias erzeugt.

**Claims**

1.  Control loop having a differential amplifier unit (100), an emitter follower (200) connected downstream of the differential amplifier unit (100) and a control unit (300), wherein the control unit (300) is configured such that it takes controlled variables (I0, Ief) both from the differential amplifier unit (100) and from the emitter follower (200) and determines at least one manipulated variable (Ubias) which controls the response of the differential amplifier unit and/or the emitter follower (200), wherein the differential amplifier unit (100) comprises a differential amplifier (101) having transistors (102, 103) and emitter resistors (108, 109), a base stage having transistors (107, 106), **characterized**
    **in that** the control loop is configured such that it compensates for a thermal drift by setting a voltage Ubias, which is connected to the bases of the transistors (107, 106) in the base stage, as manipulated variable according to the equation

    $$(Ubias - U0) = \left( \frac{Rth_{Q5}}{Rth_{Q1}} Ief + I0 \right) \cdot RG + \frac{ue}{2} ,$$

    where I0 is the total current from the differential amplifier (101) of the differential amplifier unit (100), Ief is the emitter current from the emitter follower (200), U0 is a reference voltage, RG is the resistance value of the emitter resistors (108, 109) of the differential amplifier (101), ue is the voltage difference on the bases of the transistors (102, 103) of the differential amplifier (101) and $Rth_{Q5}$ and $Rth_{Q1}$ are constants.

2.  Control loop according to Claim 1,
    **characterized**
    **in that** the base stage comprises a first transistor (107) and a second transistor (106).

3.  Control loop according to Claim 2,
    **characterized**
    **in that** the differential amplifier unit (100) comprises two load resistors (108', 109').

4.  Control loop according to Claim 3,
    **characterized**
    **in that** the differential amplifier (101) comprises a first transistor (102), which is arranged in series with a first transistor (107) of the base stage, a second transistor (103), which is arranged in series with the second transistor (106) of the base stage, and also a first emitter resistor (108) and a second emitter resistor (109), wherein the emitter resistors (108, 109) are connected to a first current source (105).

5.  Control loop according to Claim 4,
    **characterized**
    **in that** the emitter follower (200) comprises a first transistor (203), the base of which is connected to the collector of the first transistor (107) of the base stage, and a second transistor (204), the base of which is connected to the collector of the second transistor (106) of the base stage, wherein at least one second current source (201, 202) is connected to the emitter of the first transistor (203) and/or to the emitter of the second transistor (204) of the emitter follower (200).

6.  Control loop according to Claim 5,
    **characterized**
    **in that** the control unit (300) comprises a controllable voltage source (301), a difference formation unit (302) and a plurality of current controllers (303; 306).

7.  Control loop according to Claim 6,
    **characterized**
    **in that** a first current controller (303) is configured such that it carries the emitter current (Ief) from the emitter follower (200), which emitter current is produced by the second current source (201, 202).

8.  Control loop according to Claim 7,

**characterized**

**in that** a second current controller (306) is configured such that it carries the total current (I0) from the differential amplifier (101), which total current is produced by the first current source (105).

9. Control loop according to Claim 8,
**characterized**
**in that** the negative input (-) of the difference formation unit (302) has a reference voltage (U0) applied to it which corresponds to the mean value of the base voltages (U0+ue/2; U0-ue/2) from the transistors (102, 103) of the differential amplifier (101).

10. Control loop according to Claim 9,
**characterized**
**in that** the difference formation unit (302) forms the difference from the reference voltage (U0) and a voltage which is applied to the positive input (+) of the difference formation unit (302).

11. Control loop according to Claim 10,
**characterized**
**in that** the voltage which is applied to the positive input (+) of the difference formation unit (302) is formed by the voltage drop which is produced across a voltage divider by the emitter current (Ief) from the emitter follower (200), which emitter current is divided by a divisor (n), and the total current (I0) from the differential amplifier (101), which total current is divided by the same divisor (n).

12. Control loop according to Claim 11,
**characterized**
**in that** the voltage divider comprises a first resistor (307) and a transistor network (304, 305, 309, 310).

13. Control loop according to Claim 12,
**characterized**
**in that** the transistor network comprises two parallel paths which each have a common emitter transistor (304; 305) and an emitter resistor (309, 310), wherein one base of the two transistors (304, 305) is connected to the first current controller (303) and the other base of the two transistors (304, 305) is connected to the second current controller (306).

14. Control loop according to one of Claims 8 to 13,
**characterized**
**in that** the difference formation unit (30) has a voltage source (301) connected to it which is actuated by the output voltage (Ureg) from the difference unit (302) and produces the voltage Ubias.


**Revendications**

1. Circuit de réglage comportant une unité d'amplification de différence (100), un émetteur-suiveur (200) monté après l'unité d'amplification de différence (100) et une unité régulatrice (300), dans lequel l'unité de réglage (300) est configurée de sorte qu'elle détermine au moins une variable de réglage (Ubias), qui règle le comportement de l'unité d'amplification de différence et/ou de l'émetteur-suiveur (200), à partir des valeurs de réglage (I0, Ief) non seulement de l'unité d'amplification de différence (100) mais également de l'émetteur-suiveur (200), dans lequel l'unité d'amplification de différence (100) comprend un amplificateur de différence (101) comportant des transistors (102, 103) et des résistances d'émetteur (108, 109), une embase avec des transistors (107, 106),
**caractérisé en ce que**
le circuit de réglage est configuré de sorte qu'il compense une dérive thermique par le réglage d'une tension Ubias, qui est reliée à la base des transistors (107, 106) de l'embase, en tant que variable de réglage selon l'équation

$$(Ubias - U0) = \left( \frac{Rth_{Q5}}{Rth_{Q1}} Ief + I0 \right) \cdot RG + \frac{ue}{2}$$

dans laquelle I0 représente le courant total de l'amplificateur de différence (101) de l'unité d'amplification de différence (100), Ief représente le courant d'émetteur de l'émetteur-suiveur (200), U0 représente une tension de référence, RG représente la valeur de résistance des résistances d'émetteur (108, 109) de l'amplificateur de différence (101), ue représente la différence de tension aux bases des transistors (102, 103) de l'amplificateur de différence (101) et $Rth_{Q5}$ et $Rth_{Q1}$ représentent des constantes.

2. Circuit de réglage selon la revendication 1, **caractérisé en ce que**
l'embase comprend un premier transistor (107) et un second transistor (106).

3. Circuit de réglage selon la revendication 2, **caractérisé en ce que**
l'unité d'amplification de différence (100) comprend deux résistances de charge (108', 109').

4. Circuit de réglage selon la revendication 3, **caractérisé en ce que**
l'amplificateur de différence (101) comprend un premier transistor (102), qui est disposé en série avec le premier transistor (107) de l'embase, un second transistor (103), qui est disposé en série avec le second transistor (106) de l'embase, ainsi qu'une première résistance d'émetteur (108) et une seconde résistance d'émetteur (109), dans lequel les résistances d'émetteur (108, 109) sont reliées à une première source de courant (105).

5. Circuit de réglage selon la revendication 4, **caractérisé en ce que**
l'émetteur-suiveur (200) comprend un premier transistor (203), dont la base est reliée au collecteur du premier transistor (107) de l'embase, et un second transistor (204), dont la base est reliée au collecteur du second transistor (106) de l'embase, dans lequel au moins une seconde source de courant (201, 202) est reliée à l'émetteur du premier transistor (203) et/ou à l'émetteur du second transistor (204) de l'émetteur-suiveur (200).

6. Circuit de réglage selon la revendication 5, **caractérisé en ce que**
l'unité de réglage (300) comprend une source de tension pouvant être commandée (301), une unité de formation de différence (302) et plusieurs régulateurs de courant (303; 306).

7. Circuit de réglage selon la revendication 6, **caractérisé en ce que**
un premier régulateur de courant (303) est configuré de sorte qu'il est parcouru par le courant d'émetteur (Ief) de l'émetteur-suiveur (200) généré par la seconde source de courant (201, 202).

8. Circuit de réglage selon la revendication 7, **caractérisé en ce que**
un second régulateur de courant (306) est configuré de sorte qu'il est parcouru par le courant total (I0) de l'amplificateur de différence (101) généré par la première source de courant (105).

9. Circuit de réglage selon la revendication 8, **caractérisé en ce que**
à l'entrée négative (-) de l'unité de formation de différence (302) se trouve une tension de référence (U0), qui correspond à la valeur moyenne des tensions de base (U0+ue/2 ; U0-ue/2) des transistors (102, 103) de l'amplificateur de différence (101).

10. Circuit de réglage selon la revendication 9, **caractérisé en ce que**
l'unité de formation de différence (302) forme la différence entre la tension de référence (U0) et une tension, qui se trouve à l'entrée positive (+) de l'unité de formation de différence (302).

11. Circuit de réglage selon la revendication 10, **caractérisé en ce que**
la tension, qui se trouve à l'entrée positive (+) de l'unité de formation de différence (302), est formée par la chute de tension, qui est générée à un diviseur de tension par le courant d'émetteur (Ief) divisé par un diviseur (n) de l'émetteur-suiveur (200) et par le courant total (I0) divisé par le même diviseur (n) de l'amplificateur de différence (101).

12. Circuit de réglage selon la revendication 11, **caractérisé en ce que**
le diviseur de tension est constitué d'une première résistance (307) et d'un réseau de transistors (304, 305, 309, 310).

13. Circuit de réglage selon la revendication 12, **caractérisé en ce que**
le réseau de transistors est constitué de deux branches parallèles comportant respectivement un transistor (304 ; 305) en position d'émetteur et une résistance d'émetteur (309, 310), dans lequel une base des deux transistors (304, 305) est reliée au premier régulateur de courant (303) et l'autre base des deux transistors (304, 305) au second régulateur de courant (306).

**14.** Circuit de réglage selon l'une des revendications 8 à 13, **caractérisé en ce que**
à l'unité de formation de différence (30) est reliée une source de tension (301) qui est commandée par la tension de sortie (Ureg) de l'unité de différence (302) et génère la tension Ubias.

Fig. 1

Fig. 2

Fig. 3

EP 1 903 673 B1

Fig. 5

EP 1 903 673 B1

Fig. 4

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4146844 A
- US 6753732 B